# EUROPEAN PATENT APPLICATION

(11) **EP 3 300 183 A1**
(43) Date of publication of application: **28.03.2018**
(21) Application number: 16797444.3
(22) Date of filing: 20.05.2016
(51) Int. Cl.: H01R 13/703, G01R 19/165, H01R 13/10

(54) **MONITORING SYSTEM FOR AUTOMATICALLY SETTING AND AUTOMATICALLY CUTTING OFF STANDBY CURRENT OF OUTLET DUE TO INSERTION OF PLUG AND CONTROL METHOD THEREFOR, PLUG INSERTION DETECTING UNIT, AND USB PLUG INSERTION DETECTION MODULE**

(30) Priority: 22.05.2015 KR 20150072026
(71) Applicant: Network Korea, Co., Ltd., Daegu 41436 (KR)
(72) Inventor: SHIN, Donghwan, Daegu 41403 (KR); LEE, Youngran, Daegu 41403 (KR)
(74) Representative: Isarpatent
(86) International application number: PCT/KR2016/005390
(87) International publication number: WO 2016/190622

(57) **Abstract**

A system of automatic setting and shutting down a standby current of an electrical outlet by plug insertion may include an electric outlet which includes: a plug hole into which a plug of an electrical appliance is insertable, a detector for plug insertion outputting a plug insertion detecting signal corresponding to whether the plug of the electrical appliance is inserted in the plug hole, a current detector outputting a current detecting signal corresponding to current flowing through the plug hole, a switching part mounted between a power supply cable which supplies power and the plug hole, and an electrical outlet control part connected with the detector for plug insertion, the current detector and the switching part, wherein if the electrical outlet control part determines based on the plug insertion detecting signal output from the detector for plug insertion that the electrical appliance is inserted in the plug hole at current state, not inserted in the plug hole at previous state, the electrical outlet control part outputs a control signal to the switching part and causes the switching part to be connection state so as to supply power from the power supply cable to the plug hole, and the electrical outlet control part detects current currently consumed by the plug hole based on the current detecting signal transmitted from the current detector and determines the currently detected current as a standby current of the plug hole.

## Description

### [Technical field]

The present invention relates to a system of automatic setting and shutting down a standby current of an electrical outlet by plug insertion, a method of controlling the same, a detector for plug insertion, and a module of detecting USB plug insertion.

### [Background]

Generally, a power connect device such as an electrical outlet (i.e., a socket) supplies power to electrical appliances when plugs of the electrical appliances are inserted in the power connect device.

This kind of power connect device is equipped with not only one plug insertion hole which supplies power to one electrical appliance but also a plurality of plug holes. Therefore, it takes a shape of multi outlets which supply power to one or more electrical appliances connected with each plug hole.

In case that a plug hole of a power connect device is connected with an electrical appliance, standby power is generated to be ready for starting an electrical appliance in a standby condition where an electrical appliance is not in motion.

This standby power is much less than power consumption that is generated when an electrical appliance is in motion. However, as the number of electrical appliances which consume standby power is increased, the power consumption is also increased.

Therefore, when an electrical appliance is not in motion, a user needs to remove each plug of an electrical appliance from the plug hole or to turn off the power supply switch which is installed on the power connect device to prevent the loss of this standby power, thereby causing great inconvenience according to conventional arts.

Also, if the power connect device has a function of standby power loss prevention, a user needs to be aware of a provided manual and input standby power level manually to a target electrical appliance. In this case, since it is very complicated to input the standby power level to the target electrical appliance, an ordinary user is not able to use it easily in many cases.

Furthermore, every time an electrical appliance inserted to a plug hole is changed, a user needs to input the standby power level repetitively, and it causes cumbersomeness to a user and leads a great decrease in using rate.

It is disclosed in Korean patent No. 10-1183617 that multi outlets shut down standby power and leakage current.

### [Prior Art Document]

### [Patent Document]

Korean Patent No. 10-1183617 (Date of Patent: September 11, 2012)

### [CONTENTS OF THE INVENTION]

### [Technical Problem]

Therefore, the object of the present invention is to enhance a user's convenience by automatically detecting the level of standby current from an electrical appliance being used.

Also, another object of the present invention is to shut down standby current from an electrical outlet automatically when a plug is inserted.

Other object of the present invention is to make a user or a supervisor find out the operation states of automatic setting, control of standby power and monitoring promptly and precisely when each plug is inserted to an outlet.

The objects of an exemplary embodiment of the present invention is not limited to the above-mentioned objects, and other objects which are not mentioned yet will be clearly understood to a person of ordinary skill in the art from the contents below.

### [Means for solving the problem]

A system of automatic setting and shutting down a standby current of an electrical outlet by plug insertion according to an exemplary embodiment of the present invention may include an electric outlet which includes: a plug hole into which a plug of an electrical appliance is insertable, a detector for plug insertion outputting a plug insertion detecting signal corresponding to whether the plug of the electrical appliance is inserted in the plug hole, a current detector outputting a current detecting signal corresponding to current flowing through the plug hole, a switching part mounted between a power supply cable which supplies power and the plug hole, and an electrical outlet control part connected with the detector for plug insertion, the current detector and the switching part, wherein if the electrical outlet control part determines based on the plug insertion detecting signal output from the detector for plug insertion that the electrical appliance is inserted in the plug hole at current state, not inserted in the plug hole at previous state, the electrical outlet control part outputs a control signal to the switching part and causes the switching part to be connection state so as to supply power from the power supply cable to the plug hole, and the electrical outlet control part detects current currently consumed by the plug hole based on the current detecting signal transmitted from the current detector and determines the currently detected current as a standby current of the plug hole.

The detector for plug insertion may include: a moving part disposed between an upper insertion hole and a middle insertion hole of the plug hole and being movable, an elastic member connected with the moving part and changing a state thereof according to moving state of the moving part, and a switch positioned close to the moving part and changing a contact state thereof according to the moving state of the moving part so as to output a plug insertion detecting signal of the corresponding state.

The moving part may be rotated, moved linearly to the left or the right, moved linearly and vertically by force applied due to insertion of the plug of the electrical appliance into the upper insertion hole such that the middle insertion hole is exposed.

In addition, the switch may include: a contact plate changing a position thereof as the moving part moves, a contact point positioned corresponding to the contact plate and contacting with the contact plate by movement of the moving part, an input terminal applying a predetermined voltage, and at least one output terminal outputting an output signal about whether the contact plate contacts with the contact point.

In addition, the detector for plug insertion may include: a moving part disposed between an upper insertion hole and a middle insertion hole of the plug hole and being movable, an elastic member connected with the moving part and changing a state thereof according to moving state of the moving part, an operation pin configured to penetrate through a top plate and a middle plate of the electrical outlet and moving downward by force applied when the plug of the electrical appliances inserted into the upper insertion hole, and a switch located below the operation pin, changing a contact state thereof according to downward movement of the operation pin, and outputting a plug insertion detecting signal corresponding state.

In addition, the switch may include: a contact plate located below the operation pin and changing a position thereof according to downward movement of the operation pin, a contact point positioned corresponding to the contact plate and contacting with the contact plate by downward movement of the operation pin, an input terminal applying a predetermined voltage, and at least one output terminal outputting an output signal about whether the contact plate contacts with the contact point.

The system may further include an operation state indicator connected with the electrical outlet control part, wherein the electrical outlet control part operates the operation state indicator during detecting the current.

The plug hole is a plug hole of a USB type into which a USB plug is inserted, wherein the power supply cable outputs power from a DC power supply part supplying DC power.

The detector for plug insertion includes a switch positioned close to the plug hole and changing a contact state thereof according to a state of a USB plug insertion so as to output a plug insertion detecting signal of the corresponding state.

In addition, the switch may include: a contact plate changing a position thereof according to insertion of the USB plug, a contact point positioned corresponding to the contact plate and contacting with the contact plate by the insertion of the USB plug, an input terminal applying a predetermined voltage, and at least one output terminal outputting an output signal about whether the contact plate contacts with the contact point.

The system may further include an operation state indicator connected with the electrical outlet control part, wherein the electrical outlet control part displays a state where power is applied to the plug hole on the operation state indicator so as to use the electrical appliance connected with the plug hole.

If the electrical outlet control part determines based on the plug insertion detecting signal output from the detector for plug insertion that the electrical appliance is not inserted into the plug hole, the electrical outlet control part outputs a control signal to the switching part and causes the switching part to be disconnection state such that power supplied from the power supply cable to the plug hole is blocked.

The system may further include an electrical outlet switch connected with the electrical outlet control part, wherein if the electrical outlet control part determines based on the plug insertion detecting signal output from the detector for plug insertion that the electrical appliance is inserted in the plug hole from a previous state to a current state, the electrical outlet control part determines based on a signal transmitted from the electrical outlet switch whether the electrical outlet switch is operated, wherein if the electrical outlet control part determines that the electrical outlet switch is operated, the electrical outlet control part controls a state of the switching part to become the connection state so as to supply power from the power supply cable to the plug hole, wherein the electrical outlet control part decodes the current detection signal transmitted from the current detector to detects current measured by the plug hole, and wherein the electrical outlet control part maintains the state of the switching part to be the connection state if the measured current exceeds the standby current of the electrical outlet plug, and controls the state of the switching part to become disconnection state if the measured current is the same as the standby current of the electrical outlet plug.

The system may further include a transmission device communicating with the electrical outlet control part using power line communication, wherein the electrical outlet control part transmits the standby current of the plug hole, whether the electrical appliance is connected, current consumption, and whether the switching part is operated through the transmission device.

A detector for plug insertion according to an exemplary embodiment of the present invention may include: a moving part disposed between an upper insertion hole and a middle insertion hole of a plug hole and being movable, an elastic member connected with the moving part and changing a state thereof according to moving state of the moving part, and a switch positioned close to the moving part and changing a contact state thereof according to the moving state of the moving part so as to output a plug insertion detecting signal of the corresponding state.

The moving part is rotated, moved linearly to the left or the right, moved linearly and vertically by force applied due to insertion of the plug of the electrical appliance into the upper insertion hole such that the middle insertion hole is exposed.

The switch include: a contact plate changing a position thereof as the moving part moves, a contact point positioned corresponding to the contact plate and contacting with the contact plate by movement of the moving part, and an output terminal changing a state of an output signal according to whether the contact plate contacts with the contact point.

A detector for plug insertion according to an exemplary embodiment of the present invention may include: a moving part disposed between an upper insertion hole and a middle insertion hole of a plug hole and being movable, an elastic member connected with the moving part and changing a state thereof according to moving state of the moving part, an operation pin configured to penetrate through a top plate and a middle plate of an electrical outlet and moving downward by force applied when a plug of an electrical appliances inserted into the upper insertion hole, and a switch located below the operation pin, changing a contact state thereof according to downward movement of the operation pin, and outputting a plug insertion detecting signal corresponding state.

The switch includes: a contact plate located below the operation pin and changing a position thereof according to downward movement of the operation pin, a contact point positioned corresponding to the contact plate and contacting with the contact plate by downward movement of the operation pin, an input terminal applying a predetermined voltage, and at least one output terminal outputting an output signal about whether the contact plate contacts with the contact point.

A module of detecting USB plug insertion according to an exemplary embodiment of the present invention includes: a plug hole into which a USB plug is inserted (connected), and a switch positioned close to the plug hole and changing a contact state thereof according to a state of a USB plug insertion so as to output a plug insertion detecting signal of the corresponding state, wherein the switch includes a contact plate changing a position thereof according to insertion of the USB plug, a contact point positioned corresponding to the contact plate and contacting with the contact plate by the insertion of the USB plug, an input terminal applying a predetermined voltage, and at least one output terminal outputting an output signal about whether the contact plate contacts with the contact point.

A method of controlling a system of automatic setting and shutting down a standby current of an electrical outlet by plug insertion according to an exemplary embodiment of the present invention may include: a step where an electrical outlet control part decodes a plug insertion detecting signal output from a detector for plug insertion and determines whether an electrical appliance is inserted in a plug hole at current state, not inserted in the plug hole at previous state, a step where if the electrical outlet control part determines that the electrical appliance is inserted in the plug hole at current state, not inserted in the plug hole at previous state, the electrical outlet control part controls a state of a switching part to be connection state and supplies power from a power supply cable to the plug hole, a step where the electrical outlet control part decodes a current detecting signal transmitted from a current detector so as to detect a current measured at the plug hole and determines the current as a standby current of the plug hole, and a step where the electrical outlet control part compares the currently measured current with the standby current of the plug hole, maintains the state of the switching part to be the connection state if the currently measured current exceeds the standby current of the plug hole, and controls the state of the switching part to be disconnection state so as to block power supply from the power supply cable to the plug hole if a predetermined period passes under the condition that the currently measured current is less than the standby current of the plug hole.

The electrical outlet control part detects current measured at the plug hole and operates an operation state indicator connected with the electrical outlet control part during determining the measured current as the standby current of the plug hole.

The method further includes a step where the electrical outlet control part compares the currently measured current with the standby current of the plug hole, detects the current measured at the plug hole based on the current detecting signal transmitted from the current detector if the currently measured current exceeds the standby current of the plug hole, and determines the current as current consumption of the plug hole.

If a restart signal is input, the electrical outlet control part controls the state of the switching part to be the connection state so as to supply power from the power supply cable to the plug hole and sequentially perform from the step where the currently measured current is compared with the standby current of the plug hole.

The method further includes a step where if it is determined based on the plug insertion detecting signal transmitted to the detector for plug insertion that the electrical appliance is not inserted into the plug hole, the electrical outlet control part outputs the control signal to the switching part so as to control the switching part to be disconnection state and blocks power supply from the power supply cable to the plug hole.

The method further includes a step where if the states of all switching parts remain the disconnection states for a predetermined period time, the electrical outlet control part blocks drive power supplied to the electrical outlet control part.

### [Effect of the Invention]

In the system of automatic setting and shutting down a standby current of an electrical outlet by plug insertion, a method of controlling the same, a detector for plug insertion and a module of detecting USB plug insertion according to an exemplary embodiment of the present invention, each time an electrical appliance is connected with a plug hole by using the detector for plug insertion, standby current is automatically set to the connected electrical appliance and it greatly improves a user's convenience.

Also, it is determined by measuring current consumption detected from the plug hole and comparing the current consumption with standby current corresponding to the plug hole that an electrical appliance connected with a plug hole is not in motion, the exemplary embodiment of the present invention shuts off power supply to an electrical appliance and prevents standby power consumption of the electrical appliance which is not in motion.

In addition, as the power applying to the plug hole where an electrical appliance is not connected is automatically shut off, the exemplary embodiment of the present invention prevents standby power consumption through the plug hole.

Using a power cable and an electrical outlet existing at home, current consumption and standby power of an electrical appliance are measured, controlled and monitored through power line communication.

And, the current value is transmitted to a storage using security algorithm, and it is possible for a user to monitor electrical outlet state and control based on this. Thus, the exemplary embodiment of the present invention has a voluntary energy curtailment effect.

### [BRIEF DESCRIPTION OF THE DRAWINGS]

FIG. 1 is a block diagram of an electrical outlet monitoring system according to an exemplary embodiment of the present invention.
FIG. 2 to FIG. 5 are drawings of various examples of detectors for plug insertion used in an electrical outlet monitoring system according to an exemplary embodiment of the present invention, respectively.
FIG. 6 is a drawing of an example of a module of detecting USB plug insertion used in an electrical outlet monitoring system according to an exemplary embodiment of the present invention.
FIG. 7 shows examples of transmission codes between an electrical outlet control part and an electrical outlet monitoring device which is a server and explanations thereof according to an exemplary embodiment of the present invention.
FIG. 8 shows an example of electrical outlet state data transmitted between an electrical outlet control part and an electrical outlet monitoring device which is a server according to an exemplary embodiment of the present invention.
FIG. 9 to FIG. 11 are flowcharts of operation of an electrical outlet control unit of an electrical outlet according to an exemplary embodiment of the present invention, respectively.
FIG. 12 is a flowchart of operation of a transmission control unit of a transmission device according to an exemplary embodiment of the present invention.
FIG. 13 is a flowchart of operation of an electrical outlet monitoring device according to an exemplary embodiment of the present invention.

### [Best mode for executing the invention]

As the present invention may be embodied as various exemplary embodiments and their modifications, the present invention will illustrate specific exemplary embodiments in a figure and describe in detail. However, it should be understood that the present invention are not limited to the specific embodiments but includes every modifications, equivalents, or alternatives included in the spirit and technical range of the present invention.

When it is stated that a certain constituent element is "connected with" or "accessed to" another constituent element, it should be understood that a certain constituent element may be connected with or accessed to another constituent element directly or through other constituent element therebetween.

On the other hand, when it is stated that a certain constituent element is "directly connected with" or "directly accessed to" another constituent element, it should be understood that there is not any other constituent element therebetween.

The terminology used herein is only used to explain a certain exemplary embodiment, so it does not intended to limit the present invention. A singular expression includes a plural expression unless it has a clearly different meaning in the context. In this specification, the terms of "include" or "have", etc. designate existence of characteristic, number, process, operation, constituent element, component or combination thereof written in the specification. Therefore, it should be understood that the existence of one or more characteristics, numbers, processes, operations, constituent elements, components or combinations thereof, or additional possibilities are not excluded beforehand.

Unless otherwise defined, all terminology herein, including technically or scientifically, has the same meaning as the general understanding of a person of ordinary skill in the art. Terms in a generally-used dictionary should be interpreted as the corresponding contextual meaning of related technology. Unless otherwise clearly defined, they are not interpreted ideally or formally.

Hereinafter, referring to the attached drawings, the present invention will be described in detail. Prior to this, terms or words in this specification and claims should not be limited to accepted or lexical meanings only, and should be defined as a meaning and a concept which is corresponded to the spirit of the present invention, on the basis of the principle that an inventor can define the concept of a term appropriately to describe the invention. Also, unless a technical and a scientific term to be used has another definition, it has a meaning generally known to a person or an ordinary skill in the art. In this specification and the attached drawings, well-known functions and components that may not be needed to understand the spirit of the present invention will be omitted. Drawings shown below are provided as examples to deliver the spirit of the present invention thoroughly to a person of an ordinary skill in the art. Accordingly, the present invention is not limited to the drawings below and may be embodied with different forms. And, throughout the specification, the same reference numbers indicate the same constituent elements. The same constituent elements in the drawings are indicated as the same reference numbers anywhere possible.

In the following detailed description, only certain exemplary embodiments of the present invention will be shown and described, simply by way of illustration. As those skilled in the art would realize, the described embodiments may be modified in various different ways, all without departing from the spirit or scope of the present invention. Accordingly, the drawings and description are to be regarded as illustrative in nature and not restrictive. Like reference numerals designate like elements throughout the specification.

Then, referring to the accompanying drawing, a system of automatic setting and shutting down a standby current of an electrical outlet by plug insertion, a method controlling the same and a detector for plug insertion according to an exemplary embodiment of the present invention will be described.

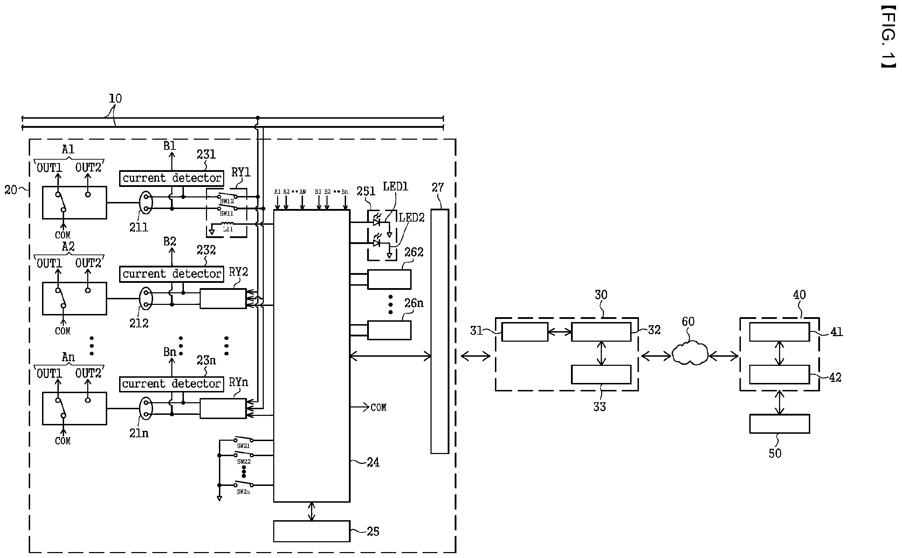

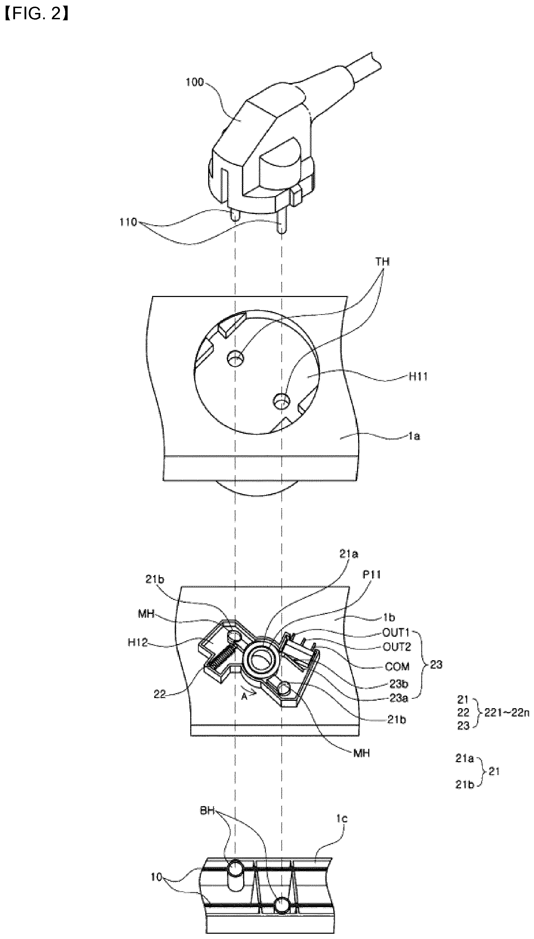

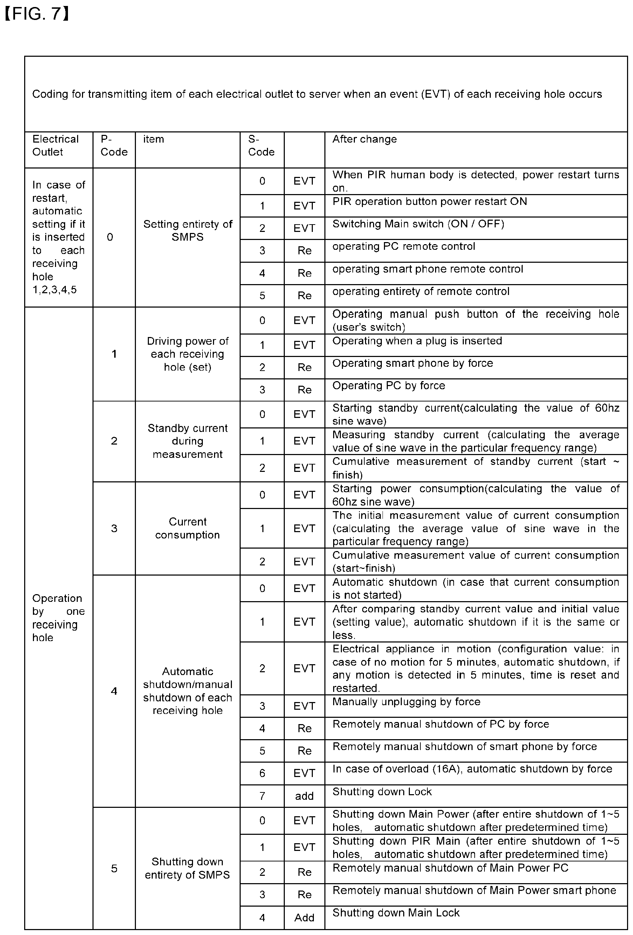

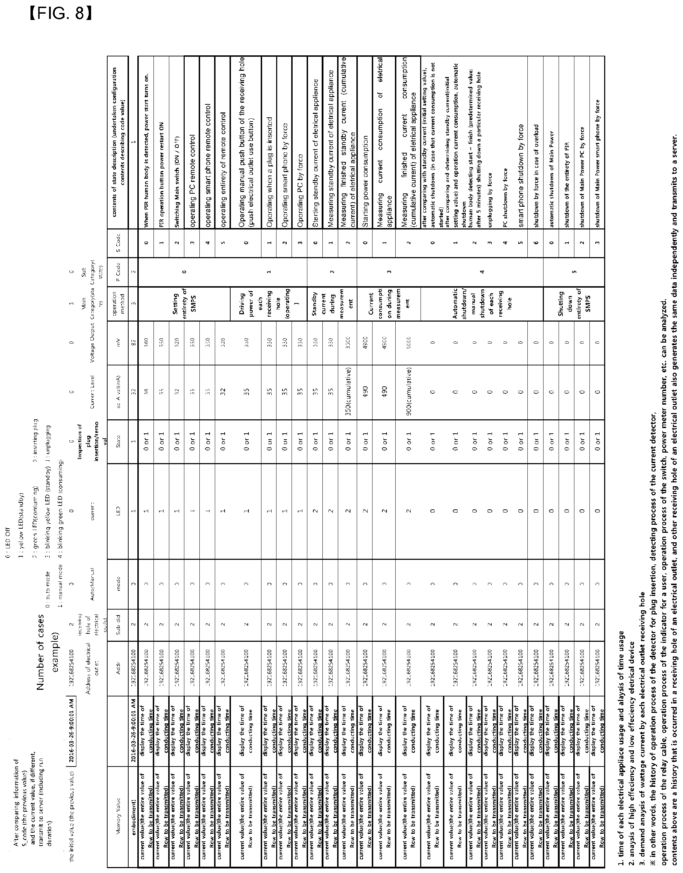

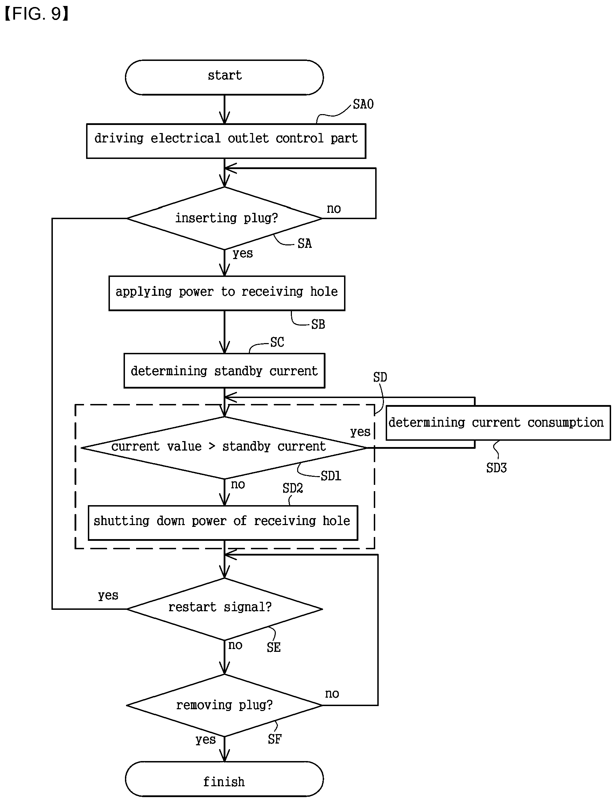

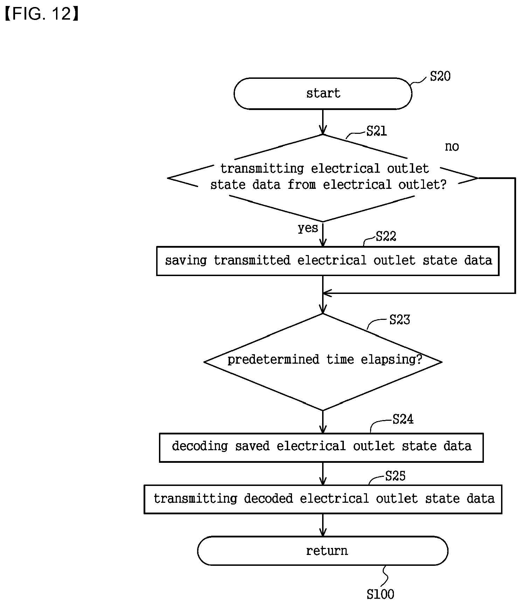

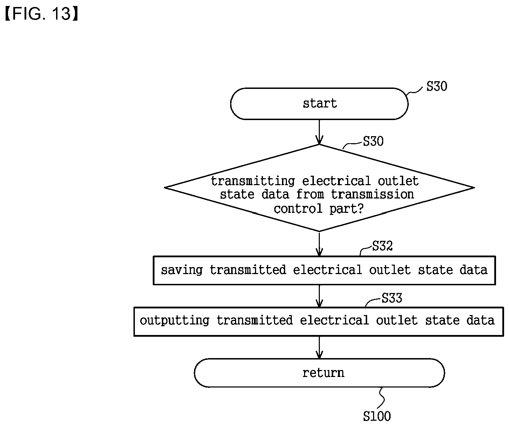

FIG. 1 is a block diagram of an electrical outlet monitoring system according to an exemplary embodiment of the present invention, and FIG. 2 to FIG. 5 are drawings of various examples of detectors for plug insertion used in an electrical outlet monitoring system according to an exemplary embodiment of the present invention, respectively. FIG. 7 shows examples of transmission codes between an electrical outlet control part and an electrical outlet monitoring device which is a server and explanations thereof according to an exemplary embodiment of the present invention. FIG. 8 shows an example of electrical outlet state data transmitted between an electrical outlet control part and an electrical outlet monitoring device which is a server according to an exemplary embodiment of the present invention. FIG. 9 to FIG. 11 are flowcharts of operation of an electrical outlet control unit of an electrical outlet according to an exemplary embodiment of the present invention, respectively. FIG. 12 is a flowchart of operation of a transmission control unit of a transmission device according to an exemplary embodiment of the present invention. FIG. 13 is a flowchart of operation of an electrical outlet monitoring device according to an exemplary embodiment of the present invention.

At first, referring to FIG. 1, the structure of a system of automatic setting and shutting down a standby current of an electrical outlet by plug insertion according to an exemplary embodiment of the present invention will be described.

A system of automatic setting and shutting down a standby current of an electrical outlet by plug insertion, shown in FIG. 1, has a power supply cable 10 which supplies power, such as commercial power, an electrical outlet connected with the power supply cable 10, i.e., power connect device 20, a transmission device 30 connected with the power connect device 20, an electrical outlet monitoring device 40 connected with the transmission device 30 through communication networks 60, and a storage 50 connected with the electrical outlet monitoring device 40.

The power supply cable 10 supplies power, such as commercial AC (alternating current) power (220V etc.) or DC power.

At this time, when DC power is supplied through the power supply cable 10, the power which is output from a DC power supply part can be supplied through the power supply cable 10 and an SMPS (Switching Mode Power Supply) can be used as the DC power supply part.

The DC power supply part supplies (outputs) DC power which is usable in a USB terminal.

At this moment, the DC power supply part may receive or use commercial AC (alternating current) power (220V etc.) or DC power. Or, a battery can be used as the DC power supply part.

In other words, the DC power supply part converts external power to power which can be used in an electronic device receiving power through a plug main body 100. Or, the DC power supply part has a battery installed therein and supplies DC power which is usable in the plug main body 100.

The power connect device 20 is connected with at least one electrical appliance, and supplies power to the electrical appliance from the power supply cable 10.

The power connect device 20 may be equipped with a plurality of plug holes (receiving holes) 211-21n into which each plug (including a USB plug) of the electrical appliance can be inserted, a plurality of electrical outlet switches SW21-SW2n corresponding to each plug hole 211-21n, a main switch that can shut off power connection of each plug hole 211-21n, a plurality of detectors for plug insertion 221-22n connected with each plug hole 211-21n, a plurality of relay cables (i.e., a plurality of switching parts) RY1-RYn connected with the power supply cable 10 and each plug hole 211-21n, a plurality of current detectors 231-23n connected between each plug hole 211-21n and each relay cable RY1-RYn connected to each plug hole 211-21n, an electrical outlet control part 24 connected with the plurality of electrical outlet switches SW21-SW2n, the plurality of detectors for plug insertion 221-22n, the plurality of current detectors 231-23n and the plurality of relay cables RY1 -RYn, a storage 25 connected with the electrical outlet control part 24, a plurality of operation state indicators 261-26n connected with the electrical outlet control part 24 and a communication part connected with the electrical outlet control part 24.

At this time, a main switch (not shown) which can shut off the entire power of the plurality of plug holes 211-21n may be further included.

The plurality of plug holes 211-21n, as described above, is connected with the power supply cable 10 through each corresponding relay cable RY1-RYn and supplies power from the power supply cable 10 to the electrical appliance inserted therein.

In this exemplary embodiment, the power connect device 20 is equipped with the plurality of plug holes 211-21n, but may be equipped with only one plug hole. In this case, the number of detectors for plug insertion, the number of the current detector relay cables and the number of the electrical outlet switches should be one to correspond to the plug hole, respectively.

The plurality of electrical outlet switches SW21-SW2n are switches that a user activates to use the electrical appliance inserted into the corresponding plug holes 211-21n. Before using the electrical appliance, a user activates the electrical outlet switches SW21-SW2n to output a signal of the corresponding operation state to the electrical outlet control part 24.

Accordingly, the electrical outlet control part 24 determines whether the corresponding electrical outlet switch SW21-SW2n is in motion using the signal from the corresponding electrical outlet switch SW21-SW2n.

If the electrical outlet switch SW21-SW2n is in motion, the electrical outlet control part 24 activates the relay cable RY1-RYn connected with the corresponded plug hole 211-21n and supplies power from the power supply cable 10 to the corresponding plug hole 211-21n, and causes the electrical appliance connected with the corresponding plug hole 211-21n to operate.

The plurality of detectors for plug insertion 221-22n has the same structure, detects whether a plug of the electrical appliance is inserted into each plug hole 211-21n, and outputs a detection signal A1-An corresponding thereto to the electrical outlet control part 24.

Accordingly, the plurality of detectors for plug insertion 221-22n is installed in the power connect device 20 corresponding to each plug hole 211-21n.

When the electrical appliance is inserted to the connected plug hole 211-21n, each detector for plug insertion 221-22n changes its state by insertion of the electrical appliance. It leads a change of the state from each output terminal OUT1 and OUT2 and outputs detection signal A1-An of the state [e.g. OUT1= 1', OUT2 ='0' (the first state)] to the electrical outlet control part 24 through output terminals OUT1 and OUT2.

On the contrary, when the plug of an electrical appliance which was inserted to the plug hole 211-21n is unplugged, the state of the detector for plug insertion 221-22n returns to the initial state, and outputs another detection signal A1-Anof the state [e.g. OUT1= 1', OUT2 ='0' (the second state)], which is different from the first state, to the electrical outlet control part 24 through the output terminals OUT1 and OUT2.

Therefore, the electrical outlet control part 24 determines whether the plug of the electrical appliance is inserted into the plug hole 211-21n using the state of the detection signal A1-An input from each detector for plug insertion 221-22n.

Referring to FIG. 2 to FIG. 5, various structures of the detectors for plug insertion 221-22n will be described.

In FIG. 2 to FIG. 5, the same reference numerals are assigned to the constituent elements having the same structures and conduct the same functions, and detailed description thereof will be omitted.

Firstly, referring to FIG. 2, the power connect device 20 includes a plug main body insertion hole H11 into which a plug main body 100 formed of a plug 110 of the electrical appliance is inserted, a top plate 1a formed of an upper insertion hole TH into which the plug 110 of the electrical appliance is firstly inserted, a middle plate 1b positioned below the top plate 1a and formed of the detector for plug insertion 221-22n and a middle insertion hole MH corresponding to the upper insertion hole TH, and a bottom plate 1c positioned below the middle plate 1b and formed of a lower insertion hole BH located corresponding to the middle insertion hole MH and on which the power supply cable 10 is located.

Therefore, the upper insertion hole TH, the middle insertion hole MH and the lower insertion hole BH of the socket 20, corresponding to each other, forms the plug hole 211-21n. In addition, the plug 110 of the electrical appliance goes through the upper insertion hole TH, the a middle insertion hole MH, and the lower insertion hole BH sequentially and is connected with the power supply cable 10 in the lower insertion hole BH

As described before, each detector for plug insertion 221-22n is formed corresponding to each plug hole 211-21n and is equipped in a mounting recess H12 in the middle plate 1b, as shown in FIG. 2.

Referring to FIG. 2, the detector for plug insertion 221-22n is located below the upper insertion hole TH, and includes a moving part 21 which is movable (rotatable), an elastic member 22 which is connected with the moving part 21 and changes a state by a moving state (e.g., rotating state) of the moving part 21, and a switch 23 which changes a contact state by the moving state of the moving part 21.

The moving part 21 may include an insertion hole 21a inserted to a protrude part P11 protruded from mounting recess H12 and a pair of blocking plates 21b respectively located at the opposite sides with the insertion hole 21a being located between the pair of blocking plates 21b.

A pin (not shown) or like is inserted to the protrude part P11, thereby preventing the moving part 21 inserted to the protrude part P11 from separation.

The pair of blocking plates 21b are slanted in the opposite directions to each other. Each blocking plate 21b blocks the middle insertion hole MH located on the bottom of the blocking plate 21b.

The elastic member 22 is located between any one of the pair of blocking plates 21b and the mounting recess H12. The elastic member 22 may be compressed or uncompressed according to the rotation of the blocking plates 21b.

The switch 23 is closely located to the pair of blocking plates 21b and includes a contact plate 23a which has an elastic force, such as a plate spring which changes a location thereof by physical force applied thereto according to the rotation of the pair of blocking plates 21b, a contact point 23b located corresponding to the contact plate 23a and contacting with the contact plate 23a or not according to the position of the contact plate 23a, a common terminal COM applying a predetermined voltage (e.g., 5V) and changing a connection state according to the contact state between the contact plate 23a and the contact point 23b, and first and second output terminals OUT1 and OUT2 contacting with the common terminal COM or not according to the contact state between the contact plate 23a and the contact point 23b.

At this time, the common terminal COM may be connected with the electrical outlet control part 24 or a separate power terminal.

For example, if the plug is inserted into the corresponding plug hole 211-21n, the contact plate 23a and the contact point 23b contact with each other and the common terminal COM contacts with the first output terminal OUT1 and does not contact with the second output terminal OUT2. On the contrary, if the plug is separated from the corresponding plug hole 211-21n, the contact plate 23a is separated from the contact point 23b and the common terminal COM contacts with the second output terminal OUT2 and does not contact with the first output terminal OUT1. Therefore, the signal of the corresponding state (the first state or the second state) is output to the electrical outlet control part 24 through the first and second output terminals OUT1 and OUT2.

This operation of the detector for plug insertion 221-22n will be described as below.

When the plug of an electrical appliance is inserted into the upper insertion hole, it goes through the upper insertion hole and contacts a surface of the pair of blocking plates 21b.

If the plug of the electrical appliances is further inserted in the upper insertion hole, the plug of the electrical appliance exerts physical force to slanted surfaces of the pair of blocking plates 21b slanted in the opposite directions to each other. The elastic member 22 changes from the initial state to the compressed state by the physical force and the pair of blocking plates 21 rotates toward the elastic member 22 about the protrude part P11 (e.g., to A direction).

Therefore, the plug of the electrical appliance moves downward along the surfaces of the pair of blocking plates 21b and causes the blocking plates 21b to move to A direction. Therefore, the middle insertion holes MH is exposed which was blocked by the pair of blocking plates 21b. Therefore, the plug of the electrical appliance is inserted into and goes through the middle insertion hole MH and is then inserted into the lower insertion holes BH.

If the pair of blocking plates 21b rotates completely by the insertion of the plug of the electrical appliance, i.e., the plug of the electrical appliance is inserted into the middle insertion hole MH completely, the contact plate 23a of the switch 23 is pushed toward the contact point 23b by the rotating blocking plates 21b and contacts with the contact point 23b.

When the contact plate 23a contacts with the contact point 23b, the common terminal COM contacts with the first output terminal OUT1, the state of the signal output to the output terminals OUT1 and OUT2 becomes the first state and the first signal is output as the detection signal A1-An.

If the plug of the electrical appliance is released from the corresponding plug hole 211-21n, the physical force exerted on the elastic member 22 vanishes and the elastic member 22 returns to its initial state. In this case, the pair of blocking plates 21b moves to their initial state by the returning operation of the elastic member 22 and blocks the middle insertion holes MH.

If the pair of blocking plates 21b returns their initial state, the physical force exerted on the contact plate 23a of the switch 23 also vanishes by the blocking plates 21b and the contact plate 23a also returns to its initial state. Therefore, the contact plate 23a is separated from the contact point 23b.

The common terminal COM contacts with the second output terminal OUT2 and does not contact with the first output terminal OUT1 by separation of the contact plate 23a from the contact point 23b such that the state of the signal output to the output terminals OUT1 and OUT2 becomes the second state and the second state is output as the detection signal A1-An.

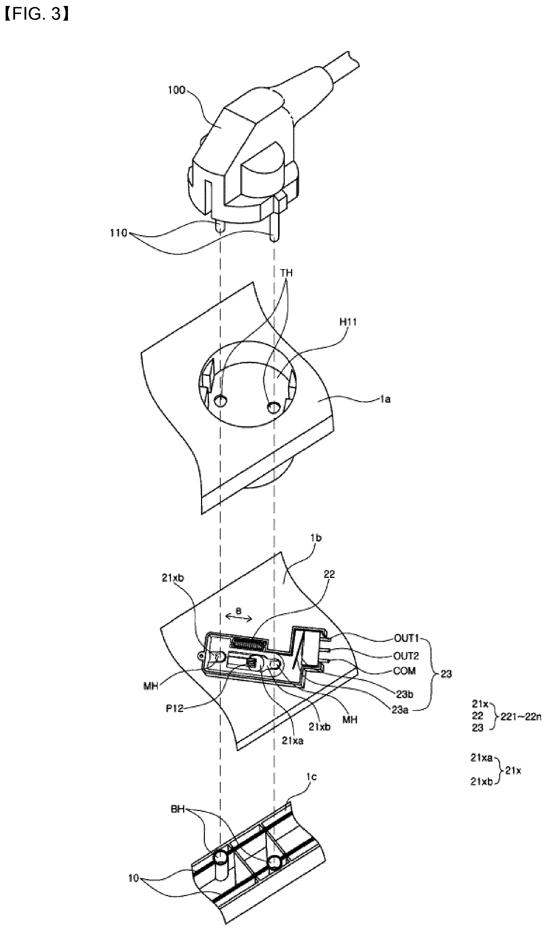

Another example of the structure of the detectors for plug insertion 221-22n is illustrated in FIG. 3.

The detector for plug insertion 221-22n illustrated in FIG. 3, the same as that illustrated in FIG. 2, is located in the mounting recess H12 of the middle plate 1b and includes the moving part 21x located below the upper insertion hole TH and being movable (e.g., linearly movable), the elastic member 22 positioned between the moving part 21x and the mounting recess H12 and changing its sate according to a moving state of the moving part 21x, and the switch 23 changing the contact state by the moving state of the moving part 21.

The moving part 21x includes the insertion hole 21xa inserted to the protrude part P12 protruded from the mounting recess H12 and the pair of blocking plates 21xb respectively located at the opposite sides with the insertion hole 21xa being located therebetween and blocking the middle insertion holes MH on the bottom of the blocking plates 21xb.

The moving part 21x illustrated in FIG. 3, different from the moving part 21 illustrated in FIG. 2, does not rotate (to A direction) but moves linearly [e.g., to left or right direction B] by the plug insertion of the electrical appliance. Therefore, slanting direction of the slanted surface of the pair of blocking plates 21xb are the same [that is, slanted to an opposite direction from the switch 23].

Also, while the insertion hole 21a illustrated in FIG. 2 has a circular cross-section, the insertion hole 21xa illustrated in FIG. 3 has an oval cross-section.

Therefore, if the plug of the electrical appliance goes through the upper insertion hole TH, contacts with the slanted surfaces of the blocking plates 21xb of the moving part 21x, and exerts physical force on the slanted surfaces, the moving part 21x moves linearly toward the switch 23 and exerts force on the contact plate 23a of the switch 23 to contact the contact plate 23a with the contact point 23b.

If the plug of the electrical appliance is separated, the blocking plates 21xb returns to its initial position by restoring force of the elastic member 22 and the contact plate 23a does not contact with the contact point 23b.

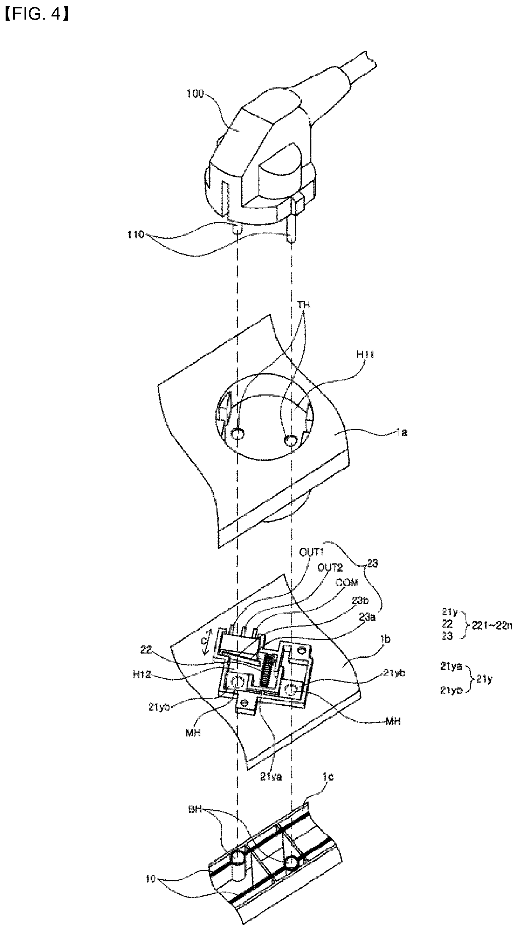

In addition, the detector for plug insertion 221-22n illustrated in FIG. 4, similar to the detectors illustrated in FIG. 2 and FIG. 3, includes the moving part 21y located below the upper insertion hole TH and being movable, the elastic member 22 positioned between the moving part 21y and the mounting recess H12 and changing its state by the moving state of the moving part 21y, and the switch 23 changing the contact state by the moving state of the moving part 21y.

The moving part 21y does not rotate but moves linearly.

However, a moving direction of the moving part 21y of the detector for plug insertion 221-22n illustrated in FIG. 4 crosses the moving direction B illustrated in FIG. 3 [i.e., forward or rearward direction C].

For this purpose, the moving part 21y includes a center part 21ya contacting with the elastic member 22 and the pair of blocking plates 21yb located at the opposite sides with the center part 21ya being located therebetween and corresponding to the upper insertion hole TH and the middle insertion hole MH and blocking the middle insertion hole MH.

The pair of blocking plates 21yb has the slanted surfaces slanted to the same direction [that is, slanted to an opposite direction from the switch 23].

Therefore, if the plug of the electrical appliance goes through the upper insertion hole TH, contacts with the slanted surfaces of the blocking plates 21yb of the moving part 21y, and exerts physical force on the slanted surfaces, the moving part 21y moves linearly toward the switch 23 and exerts force on the contact plate 23a of the switch 23 to contact the contact plate 23a with the contact point 23b. If the plug of the electrical appliance is separated, the blocking plates 21yb returns to its initial position by restoring force of the elastic member 22 and the contact plate 23a does not contact with the contact point 23b.

Operation of the detectors for plug insertion 221-22n illustrated in FIG. 3 and FIG. 4 is the same as that of the detector illustrated in FIG. 2 except moving directions of the moving parts 21x and 21y and slanted directions of the slanted surfaces of the blocking plates 21xb and 21yb for moving the moving parts 21x and 21y.

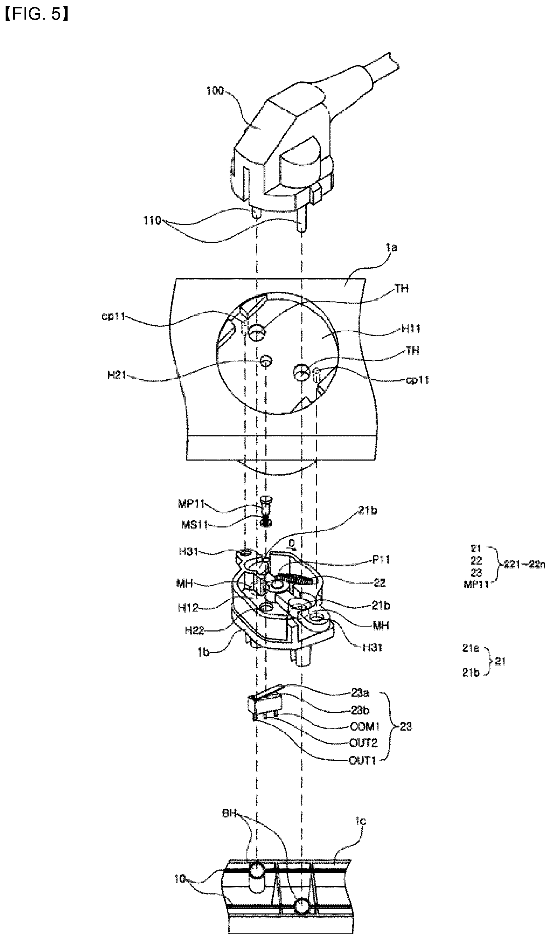

The detector for plug insertion 221-22n illustrated in FIG. 5 is positioned on the middle plate 1b and includes the moving part 21, the elastic member 22, and the switch 23 that are the same as those illustrated in FIG. 2.

Therefore, the moving part 21 includes the pair of blocking plates 21b slanted to the opposite directions to each other and may be inserted into the protrude part P11 protruded from the mounting recess H12 so as to rotate to a corresponding direction D about the protrude part P11.

Therefore, if the plug 110 of the plug main body 100 is inserted into the upper insertion hole TH and exerts physical force on the pair of blocking plates 21b, the pair of blocking plates 21b rotates to the direction D about the protrude part P11 and opens the middle insertion holes MH located below the blocking plates 21b. In this case, the plug 110 is inserted into the opened middle insertion hole MH and is then inserted into the lower insertion hole BH.

Similar to the description referring to FIG. 2, if the plug 110 is separated from the upper insertion hole TH, the moving part 21 returns to its initial position by the restoring force of the elastic member 22 and blocks the middle insertion hole MH.

However, different from the description referring to FIG. 2, the switch 23 illustrated in FIG. 5 is not located at a side portion of the moving part 21 but is located bellows the moving part 21.

Therefore, the detector for plug insertion 221-22n further includes a through-hole H21 formed in the plug main body insertion hole H11 of the top plate 1a and an operation pin MP11 inserted in a through-hole H22 formed in the mounting recess H12 of the middle plate 1b. An elastic member MS11 is positioned at a center portion of the operation pin MP11.

The operation pin MP11 penetrates through the through-hole H21, i.e., penetrates through the top plate 1a, and is protruded from the plug main body insertion hole H11. After that, the operation pin MP11 penetrates the through-hole H22, i.e., penetrates through the middle plate 1b and closely located to the contact plate 23a of the switch 23.

When the plug 111 is inserted into the upper insertion hole TH of the plug main body insertion hole H11, an upper portion of the operation pin MP11 penetrating through the through-hole H21 contacts with the plug main body 100 and then moves downward by force exerted by the plug main body 100.

A lower portion of the operation pin MP11 pushes the contact plate 23a of the switch 23 positioned below the operation pin MP11 and causes the contact plate 23a to contact with the contact point 23b by downward movement of the operation pin MP11.

Through the contact state of the contact plate 23a and the contact point 23b, the state of the signal is outputted to the first and second output terminals OUT1 and OUT2 and insertion of the plug 110 can be detected.

On the contrary, if the plug 110 is separated, the operation pin MP11 returns to the initial state by the restoring force of the elastic member MS11 and protruded from the upper insertion hole TH. Therefore, the contact plate 23a of the switch 23 that contacted with the contact point 23b returns to its initial position and does not contact with the contact point 23b. Therefore, the corresponding state of the detection signal is output to the output terminals OUT1 and OUT2.

The middle plate 1b provided with the detector for plug insertion 221-22n is fixed mounted between the top plate 1a and the bottom plate 1c by inserting an insertion pin CP11 positioned at the top plate 1a into an insertion hole H31.

According to the present exemplary embodiment, the switch 23 may have one input terminal COM and two output terminals OUT1 and OUT2. However, the switch 23 is not limited to three-terminal switch and may have one input terminal and one output terminal.

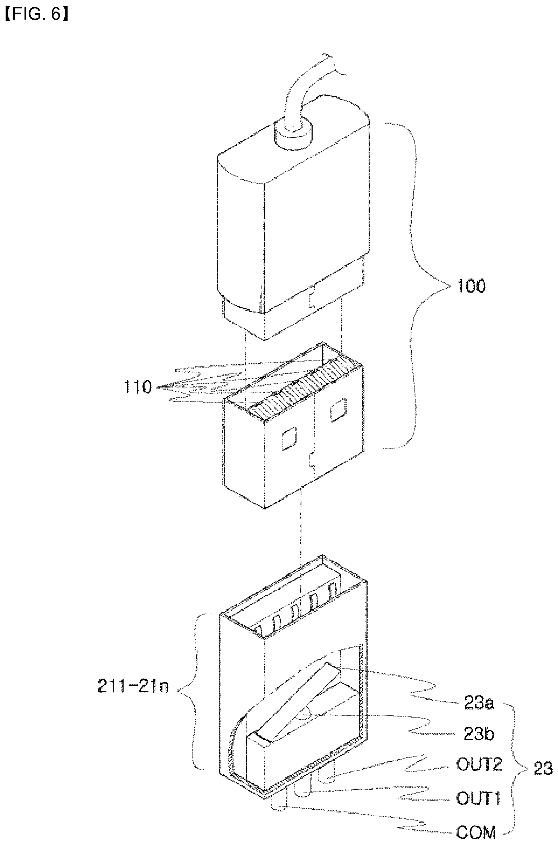

As shown in FIG. 6, the detector for plug insertion 221-22n may include the switch 23 positioned close to the plug hole 211-21n. The switch 23 changes the contact state according to the insertion state of the plug main body 100 and outputs a plug insertion detecting signal corresponding to the insertion state.

That is, a USB plug is fitted into the plug hole 211-21n and pushes the switch.

Various types of the detectors for plug insertion 221-22n may be used, but one example of the detectors will be described with reference to FIG. 6.

A plug (wiring) 111 is formed at the plug main body 100 according to a type thereof.

It is illustrated in FIG. 6 that five plugs 111 are formed but the present invention is not limited to the five plugs 111. Four wirings are formed according to a standard type and five wirings are formed according to mini or micro type. In addition, various USB wirings may be formed.

Each detector for plug insertion 221-22n, as described above, is mounted corresponding to one plug hole 211-21n.

At this time, as shown in FIG. 6, the detector for plug insertion 221-22n may be mounted at an end of the plug hole 211-21n. However, a position of the detector is not limited to the position illustrated in FIG. 6 according to the present invention. That is, the detector for plug insertion 221-22n may be mounted at a side surface of the plug hole 211-21n.

The switch 23 is positioned close to the plug hole 211-21n and includes the contact plate 23a which has an elastic force, such as a plate spring which changes a location thereof by physical force generated when the USB plug is fitted into the plug hole 211-21n, the contact point 23b located corresponding to the contact plate 23a and contacting with the contact plate 23a or not according to the position of the contact plate 23a, the common terminal COM applying a predetermined voltage (e.g., 5V) and changing a connection state according to the contact state between the contact plate 23a and the contact point 23b, and first and second output terminals OUT1 and OUT2 contacting with the common terminal COM or not according to the contact state between the contact plate 23a and the contact point 23b.

At this time, the common terminal COM may be connected with the terminal control part 24 or a separate power terminal..

For example, if the plug is inserted into the corresponding plug hole 211-21n, the contact plate 23a and the contact point 23b contact with each other and the common terminal COM contacts with the first output terminal OUT1 and does not contact with the second output terminal OUT2. On the contrary, if the plug is separated from the corresponding plug hole 211-21n, the contact plate 23a is separated from the contact point 23b and the common terminal COM contacts with the second output terminal OUT2 and does not contact with the first output terminal OUT1. Therefore, the signal of the corresponding state (the first state or the second state) is output to the electrical outlet control part 24 through the first and second output terminals OUT1 and OUT2.

If the USB plug is inserted into the plug hole 211-21n completely, the contact plate 23a of the switch 23 is pushed toward the contact point 23b by the USB plug and contacts with the contact point 23b.

When the contact plate 23a contacts with the contact point 23b, the common terminal COM contacts with the first output terminal OUT1, the state of the signal output to the output terminals OUT1 and OUT2 becomes the first state and the first signal is output as the detection signal A1-An.

If the USB plug is separated from the plug hole 211-21n completely, physical force exerted on the contact plate 23a of the switch 23 by the USB plug vanishes and the contact plate 23a returns to its initial state. Therefore, the contact plate 23a does not contact with the contact point 23b.

The common terminal COM contacts with the second output terminal OUT2 and does not contact with the first output terminal OUT1 by separation of the contact plate 23a from the contact point 23b such that the state of the signal output to the output terminals OUT1 and OUT2 becomes the second state and the second state is output as the detection signal A1-An.

According to the exemplary embodiment shown in FIG. 2, the switch 23 may have one input terminal COM and two output terminals OUT1 and OUT2. However, the switch 23 is not limited to three-terminal switch and may have one input terminal and one output terminal.

Each of the plurality of current detectors 231-23n is connected with each plug hole 211-21n, detects current consumption of the each plug hole 211-21n, and outputs a signal B1-Bn corresponding thereto to the electrical outlet control part 24,

Therefore, the electrical outlet control part 24 detects current consumption of each plug hole 211-21n based on the detection signal B1-Bn transmitted from the plurality of current detector 231-23n.

Each of the plurality of relay cables RY1-RYn has the same structure as another relay cable RY1-RYn and is located between the electrical outlet control part 24 and each plug hole 241-24n.

Each relay cable RY1-RYn changes an operation state according to the control signal from the electrical outlet control part 24, and controls supply of power to each plug hole 211-21n [i.e., power through the power supply cable 10].

The relay cable RY1-RYn includes a coil L11 having one terminal connected with the electrical outlet control part 24 and the other terminal being grounded, and switches SW11 and SW12. One terminal of each switches SW11 and SW12 is connected with the power supply cable 10 and the other terminal of each switches SW11 and SW12 is connected with the plug hole 211-21n.

Accordingly, when the coil L11 of each relay cable RY1-RYn is magnetized or the switch SW11 and SW12 is on by releasing the magnetization through the control signal from the electrical outlet control part 24, power is supplied to the plug hole 211-21n connected with the relay cable RY1-RYn.

Accordingly, the power of the plug hole 241-24n supplied from the power supply cable 10 through the relay cable RY1-RYn is supplied to and activates the electrical appliances, such as home appliances, servers or power supply devices, which are connected with the plug hole 241-24n using the plug.

When the plug of the electrical appliance is inserted into the plug hole 211-21n, the electrical outlet control part 24 measures the amount of current consumption using the detection signal B1-Bn from the current detector 231-23n. Then, the electrical outlet control part 24 determines the standby power level of the electrical appliance connected with the plug hole 211-21n using the detection signal A1-An from the detector for plug insertion 221-22n.

After that, the electrical outlet control part 24 determines whether to use the electrical appliance by using the current level consumed from the plug hole 211-21n where the electrical appliance is inserted and the amount of determined standby current. When the connected electrical appliance is in motion, the electrical outlet control part 24 supplies power from the power supply cable 10 to the plug hole 211-21n by controlling the relay cable RY1-RYn. When the connected electrical appliance is not in motion, the electrical outlet control part 24 cuts off power from the power supply cable 10 to the plug hole 211-21n.

The storage 25 is a memory. The storage 25 saves the amount of standby current connected with each plug hole 211-21n, data which is needed to activate the electrical outlet control part 24 and data which is produced during the operation. The storage 25 may be equipped in the electrical outlet.

Different from FIG. 1, this storage 25 may be located inside of the electrical outlet control part 22.

The plurality of operation state indicators 261-26n is installed corresponding to each plug hole 211-21n. The operation state indicators 261-26n is operated for predetermined time by the control of electrical outlet control part 24 and indicates a state of each plug hole 211-21n to a user outside.

The plurality of operation state indicators 261-26n has the same structure, and each operation state indicator 261-26n is connected between the electrical outlet control part 24 and the ground. The operation state indicators 261-26n includes is equipped with light emitting diodes LED1 and LED2 which emit different colors (e.g. red, yellow, green, blue etc.).

The first light emitting diode 261 can indicate the state that the standby current of an electrical appliance inserted into the plug hole 211-21n is in measurement (e.g. green). The second light emitting diode 262 can indicate the state that power is allowed to the plug hole 211-21n (e.g. blue) to use the electrical appliance inserted into the plug hole 211-21n.

In addition, if equipped, the third light emitting diode can indicate the state that standby power is blocked (e.g. red), and the fourth light emitting diode can indicate the state that electrical appliance is in motion (e.g. yellow).

The communication part 27 is a communication module for communicating with the transmission device 30 and controls communication with the transmission device 30.

In this example, the communication part 27 controls power line communication (PLC) with the transmission device 30. However, it is not limited to this, but can control another type of wired communication or wireless communication, as well.

The transmission device 30 includes a communication part 31 for communicating with the power connect device 20, a transmission control part 32 connected with the communication part 31, and a storage 33 connected with the transmission control part 32.

The communication part 31, like the communication part 27 of the power connect device 20, is a communication module for wired or wireless communication like PLC.

The transmission control part 32 saves electrical outlet state data, which is an operation state of each plug hole 211-21n, each relay cable RY1-RYn and current detector 231-23n, to the storage 33, through the communication part 31. The transmission control part 32 sends the information to the electrical outlet monitoring device 40 at predetermined interval or every time plug insertion detecting signal from the detector for plug insertion or the current detecting signal from current detector is changed.

The storage 33, as described above, is a memory that saves electrical outlet state data and can be located inside of the transmission control part 32, different from FIG. 1.

The electrical outlet monitoring device 40 includes a monitoring control part 41 and a data output part 42 connected with the monitoring control part 41.

This electrical outlet monitoring device 40 can be a smart phone, a server, a laptop or a computer such as a personal computer, and so on.

The monitoring control part 41 determines the operation state of the power connect device 20, using the electrical outlet state data transmitted from the transmission device 30.

For example, the monitoring control part 41 can monitor whether the plug main body is inserted into the detector for insertion, the current detected from a current detector, the operation state of a switch, and so on.

The electrical outlet state data includes the standby current of each plug hole 211-21n, whether the electrical appliance is connected, the current consumption level, and whether the relay cable RY1-RYn is in motion, and the monitoring control part 41 outputs electrical outlet state data to data output part 42 and determines the states of each plug hole 211-21n and each relay cable RY1-RYn.

The data output part 42 may be a liquid crystal display device (LCD) or an organic light emitting diode device (OLED), and indicates the operation state of the power connect device 20 by the control of the monitoring control part 41.

The storage 50 may be a memory or a database, etc. If the storage 50 is the memory, the storage 50 may be located inside of the monitoring control part 41.

Event occurrence and the consequent control according to an exemplary embodiment of the present invention will be described.

FIG. 7 shows available transmission codes transmitted between the electrical outlet control part 24 and the electrical outlet monitoring device 40 as a server and explanation thereof according to an exemplary embodiment of the present invention,. In other words, FIG. 7 shows a code in accordance with event occurrence. In FIG. 7, main category, sub category and the combination of these two are named and described as P_code, S_code and PS_code, respectively.

According to an exemplary embodiment of the present invention, FIG. 8 shows examples of the electrical outlet state data transmitted between the electrical outlet control part 24 and the electrical outlet monitoring device 40 as a server.

That is, FIG. 8 shows examples of data format that is transmitted with other information including P_Code and S_Code in FIG. 7.

When the transmission device 30 transmits the electrical outlet state data (refer to FIG. 8) to the electrical outlet monitoring device 40, the monitoring control part 41 of the electrical outlet monitoring device 40 saves the transmitted electrical outlet state data to the storage 50, outputs it to the data output part 42 at step S33, and indicates the operation state of each plug hole 211-21n of the power connect device 20, the amount of present and accumulated current consumption of the plug hole 211-21n, and the operation state of each relay cable RY1-RYn on data output part 42.

Therefore, with the electrical outlet state data from the data output part 42, a manager can identify promptly and precisely whether each plug hole 211-21n is in motion, the amount of current consumption and the accumulated current consumption of each plug hole 211-21n, the connection of an electrical appliance, and the operation of relay cable.

In this exemplary embodiment, data transmission between the power connect device 20 and the electrical outlet monitoring device 40 is conducted through the transmission device 30. However, in an alternative exemplary embodiment, without an additional transmission device 30, the power connect device 20 can communicate with the electrical outlet monitoring device 40 through the communication part 27 of the power connect device 20. In this case, the operation of the transmission control part 30 of the transmission device 30 is conducted by the electrical outlet control part 24.

In other words, the history of operation process of the detector for plug insertion, detecting process of the current detector, operation process of the relay cable, operation process of the indicator for a user, operation process of the switch, power meter number, etc. can be analyzed.

FIG. 8 describes a history occurring at one receiving hole of the electrical outlet. Each electrical outlet receiving hole also generates independently the same structure of data and sends it to the server.

In the system of automatic setting and shutting down a standby current of an electrical outlet by plug insertion and a method controlling the same according to an exemplary embodiment of the present invention, the most important point is that monitoring of each receiving hole is possible. In other words, the history of power consumption of each receiving hole can be checked. In other words, it is possible to check the amount of power consumption of each electronic device connected with a receiving hole from when to when. It helps predict which electronic device should be used and how to use it to save the cost of electricity. It also helps establish a power consumption plan.

The system of automatic setting and shutting down a standby current of an electrical outlet by plug insertion according to an exemplary embodiment of the present invention includes a band-pass filter of particular frequency (e.g. 58-62 Hz). It is characterized that the band-pass filter is equipped (serial connection) to control to flow the current of only particular frequency bands (e.g. 58-62 Hz) in the electrical outlet switch,

This is to remove unnecessary noise when current is measured.

At this time, the band-pass filter can be connected (serial connection by switching operation or connection possible to disconnect only the band-pass filter) to operate or stop as needed.

The meaning of disconnecting the band-pass filter herein is to control to pass the current in the electrical outlet switch without noise removal. The meaning of operating the band-pass filter is to control to flow the current of only particular frequency bands (e.g. 58-62 Hz) in the electrical outlet switch.

At this time, it is characterized that the band-pass filter is operated during the standby current measurement.

As standby current is relatively low and it reduces the measurement reliability due to the noise, removing unnecessary noise can heighten the reliability of standby current measurement.

As described above, automatic detecting standby current of electrical outlet and monitoring system operation according to an exemplary embodiment of the present invention will be described referring to FIG. 7 to FIG. 13.

The actions of automatic measuring standby current of an electrical appliance inserted into the plug hole 211-21n by the electrical outlet control part 24 of power connect device 20 and of monitoring standby current consumption and shutting down will be described..

As shown in FIG. 9, the method of controlling the system of automatic setting and shutting down a standby current of an electrical outlet by plug insertion according to an exemplary embodiment of the present invention is to supply power to the electrical outlet control part 24 and make it start at step SA0.

In more detail, by electrically connecting power connect device 20 to power supply cable 10 or a command (code, etc.) to supply power to the electrical outlet control part 24, using AC power supplied from the power supply cable 10 connected with the power supply cable 10, the electrical outlet control part 24 receives power of the electrical outlet control part 24 from the DC power supply part (not shown) which outputs at least one DC (direct current) which is needed for operation of the power connect device 20 (the operation of detector for plug insertion, the current detector, the switching part, and the electrical outlet control part)

At this time, the command (code, etc.) to supply power to the electrical outlet control part 24 can be generated by a detecting sensor for detecting a human body (passive infrared sensor), the main switch (not shown) that can entirely shut off the plurality of plug hole 211-21n, a computer, a smart phone or a remote control and so on.

In other words, in case that the detecting sensor for detecting a human body detects a human body (PS_code 00), or that an activation button of a the detecting sensor for detecting a human body is input (PS_code 01), or that the main switch changes OFF to ON (PS_code 02), using the computer (PS_code 03), the smart phone (PS_code 04), the remote control (PS_code 05), and so on, power supply command can be generated (entirety of SMPS is set)(refer to FIG. 7).

As such, by electrically connecting the power connect device 20 to the power supply cable 10 or the command (code, etc.) to supply power to the electrical outlet control part 24, the electrical outlet control part is driven.

Then, the electrical outlet control part decodes plug insertion detecting signal from the detector for plug insertion, and determines whether the plug is inserted in the current state, not inserted in the previous state at step SA.

This is one of the methods to supply power from the power supply cable 10, in the state that the plug hole (the receiving hole) of the power connect device 20 shuts off standby current. It is to use the method of removing the plug of the electrical appliance and connecting.

After that, when the electrical outlet control part determines that the electrical appliance is inserted into the plug hole in current state, not in the previous state, the electrical outlet control part supplying power to the plug hole from the power supply cable by controlling the switching part to be connected at step SB.

In other words, when a new electrical appliance is connected, the electrical outlet control part controls to supply power to the plug hole from the power supply cable 10.

The case that the plug is inserted into the plug hole is exemplified above, but the present invention is not limited to this. In case that an electrical outlet switch (manually operated pushbutton) is changed from OFF to ON (PS_code 10), or that the plug is inserted into the plug hole (PS_code 11), the power supply command to supply (drive) power to each receiving hole can be generated using a smart phone (PS_code 12), a computer (PS_code 13), etc. (refer to FIG. 7)

Then, the electrical outlet control part decodes the current detecting signal from the current detector, measures the current value from the plug hole, and determines it as standby current of the plug hole at step SC.

In other words, as the electrical appliance is OFF state, the current value measured at that moment can be determined as the standby current. This is to reduce electricity consumption which is consumed by standby current, by shutting off power, when it is determined as standby current afterward (electrical appliances is OFF state).

Herein, the measured current value means the average value of currents measured during predetermined duration.

At this time, in each case that current detection is started to measure standby current (PS_code 20), current detection is in operation to measure standby current (PS_code 21) or current detection is finished to measure standby current (PS_code 22), the related signal (the signal which indicates that the standby current is during measurement) can be output (refer to FIG. 7).

After that, the electrical outlet control part compares the currently measured current value and the standby current value of the plug hole at step SD1. If the currently measured current value exceeds the standby current value of the plug hole, the state of the switching part is maintained as the connection state. If a certain period of time passes under the condition that the currently measured current value is less than the standby current value of the plug hole, the state of the switching part is controlled as the disconnection state. In addition, in the step SD, power supplied from the power supply cable to the plug hole is shut down at step SD2.

In other words, after measuring the current flowing in the plug hole at step SD1, power is supplied when the electrical appliance is in use at the step SD2 and power is shut down when the electrical appliance is not in use at step SD3.

Due to this, standby power consumption can be reduced.

In each case that the power applied to the plug insertion hole is blocked (automatic block) without using the electrical appliance (PS_code 40), the power applied to the plug insertion hole is shut down (automatic block) after using the electrical appliance (PS_code 41), the plug of the electrical appliance is removed (PS_code 43) during the use of the electrical appliance (PS_code 42), the power is blocked by a computer (PS_code 44) or a smart phone (PS_code 45) etc., the power is blocked by overload (PS_code 46) or the power is blocked by a block setting (PS_code 47), the related signal (the signal related to the power management of each receiving hole) can be output (refer to FIG. 7).

To change the electrical disconnection state (standby current is blocked) between the power supply cable 10 and the plug hole to the electrical connection state between them, the power connect device 20 is electrically connected to the power supply cable 10, or the plug of the electrical appliance is connected to the plug hole, or the main switch or a plug hole electrical outlet switch is changed OFF to ON, or the passive infrared sensor is used, or the remote control by a computer, a smart phone, or a remote control, etc. is possible.

At this time, it is characterized that the electrical outlet control part measures the current value detected from the plug hole, and, during deciding it as the standby current of the plug hole, activates the operation state indicator connected with the electrical outlet control part.

For example, during the measurement of the standby current, the first light emitting diode LED1 of the indicator 261-26n can be lit.

By this lighting action of the first light emitting diode LED1, a user notices that the electrical outlet control part 24 is measuring the standby current value of a newly connected electrical appliance, and a user refrains the use of the electrical appliance until the first light emitting diode LED1 is off.

Also, the electrical outlet control part compares the currently measured current value with the standby current of the plug hole. If the currently measured current value exceeds the standby current value of the plug hole, the current detecting signal transmitted from the current detector is decoded, measures current of the plug hole, and determines the current of the plug hole as current consumption at step SD3.

This can be used to control the power disconnecting by monitoring the current consumption of the electrical appliance connected with the plug hole and deciding afterward whether the electrical appliance is defective (electrical leakage, etc.).

At this moment, in each case that current detection is started to measure current consumption (PS_code 30), or current detection is in operation to measure current for measuring the standby current (PS_code 31), or current detection is finished to measure the standby current (PS_code 32), the related signal (the signal that current consumption is during measurement) can be output (refer to FIG. 7).

Also, if restart signal is input to the electrical outlet control part at step SE, the electrical outlet control part supplies power to the plug hole from the power supply cable at the step SA by controlling the state of the switching part to be connected, and then the currently measured current value is compared with the standby current value of the plug hole.

Herein, the restart signal is a signal that controls to supply power using a device, such as a passive infrared sensor, a computer, a smart phone or a remote control, etc.

In other words, this is one of the methods to supply power from the power supply cable 10 under the condition that the plug hole (receiving hole) of the power connect device 20 blocks the standby current. This is to use a restart signal.

If the electrical outlet control part determines based on the plug insertion detecting signal output from the detector for plug insertion that the electrical appliance is not inserted into the plug hole at step SF, control signal is output to the switching part such that the switching part is to become disconnection state and power supplied from the power supply cable to the plug hole is blocked.

That is, if the plug of an electrical appliance is removed from the plug hole (remove an electrical appliance), the power from the plug hole can be blocked. This can prevent a possible electrical shock or electrical leakage accident in advance.

In other words, in each case that a main switch is OFF (PS_code 50), the electrical outlet switch is OFF (PS_code 51), power is shut down by a computer (PS_code 52) or a smart phone (PS_code 53), etc. or it is blocked by a block setting (PS_code 54), the related signal (signal related to SMPS batch block signal) can be output (refer to FIG. 7).

In the above, it is exemplified that many signals (PS_code) can be generated referring to FIG. 7, but the present invention is not limited to this. It is certain that various applications may be used as the PS-code.

In addition, referring to FIG. 7, various signals (PS_code) can send information in a data format including various information, such as in FIG 8.

Moreover, if the states of all switching parts remain the disconnection states for a certain period of time, step that the electrical outlet control part shuts off driving power which is supplied to the electrical outlet control part can be further included.

In other words, when the electrical outlet is not in use for a long time, by even shutting off driving power which is supplied to the electrical outlet control part, power consumption can be further reduced.

Hereinafter, the control method of the monitoring system of automatic setting and shutting down a standby current of an electrical outlet by plug insertion according to an exemplary embodiment of the present invention will be described in detail.

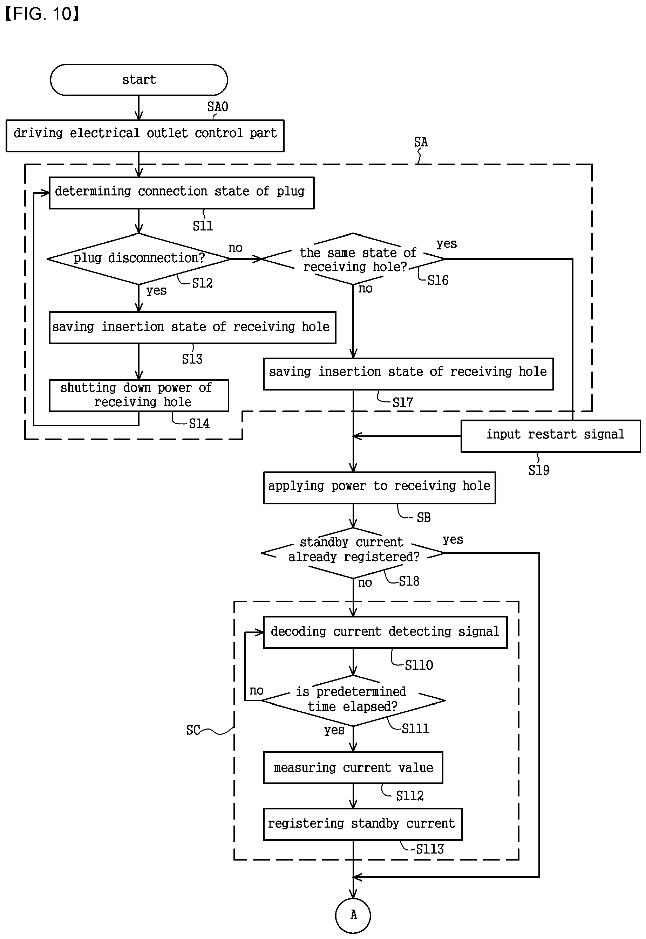

The step SA in FIG. 9 will be described with the example of FIG. 10.

When the electrical outlet control part 24 starts to activate, it firstly decodes the plug insertion detecting signal A1-An input from the plurality of detectors for plug insertion 221-22n. Then, by deciding whether the electrical appliance is inserted to each plug hole 211-21n using the state of the plug insertion detecting signal A1-An, the electrical outlet control part 24 determines the state whether an electrical appliance of each plug hole 211-21 is connected at step S11. At this moment, the result of whether the electrical appliance is connected to each plug hole 211-21n can be saved to the storage 25 as plug state data. This is to compare the previous and the current state of each plug hole 211-21n, and it is desirable that the initial value of plug state data is set to disconnection state. This is to measure standby current normally even when power is supplied to the power connect device 20 connected with the plug of an electrical appliance.

After deciding whether the electrical appliance is connected with the plug hole 211-21n at step S12, if the electrical appliance is not connected, the electrical outlet control part 22 can save the current plug insertion state (i.e., disconnection state with the electrical appliance), the current state of the determined plug hole 211-21n, to the storage 25 as a previous plug insertion state at step S13.

Then, to cause the state of the relay cable RY1-RYn connected with the plug hole 211-21n to become the disconnection state [i.e., switch SW11 and SW12 are turned off], the electrical outlet control part 22 controls the state of the signal supplied to the coil L11 S14. At this moment, in case that the relay cable RY1-RYn connected with the plug hole 211-21n is disconnected, the current state remains.

In case that the current plug insertion state (i.e., the current state) of the plug hole 211-21n is the connection state with the electrical appliance, the electrical outlet control part 22 determines whether the determined plug insertion state (i.e., the connection state with the electrical appliance) is the same as the previous plug insertion state saved to the storage 25 (i.e., the previous state) at step S16.

In case that the current plug insertion state determined at the step S12 is different from the previous plug insertion state saved to the storage 25, i.e., in case that the electrical appliance is not connected with the plug hole 211-21n in the previous stage, but is connected in the current stage (a new electrical appliance is connected), the electrical outlet control part 24 can save the determined current plug insertion state as the previous state to the storage 25 at step S17.

Back to the step S16, in case that the current plug insertion state determined at the step S12 is the same as the previous plug insertion state saved to the storage 25, i.e., in case that the electrical appliance is connected with the plug hole 211-21n from the previous stage to the current stage, when the restart signal is input from the electrical outlet switch SW21-SW2n corresponding to the plug hole 211-21n, the electrical outlet control part 24 determines that a user turns on the electrical outlet switch SW21-SW2n to operate the electrical appliance connected with the plug hole 211-21n.

Herein, the restart signal is the signal to supply power from the power supply cable 10 under the condition that the plug hole (receiving hole) of the power connect device 20 shuts down standby current. The restart signal can be input not only by changing the electrical outlet switch (manually operated push button) OFF to ON, but also by a smart phone, a computer or a remote control, etc.

Therefore, the electrical outlet control part 24 controls the state of the relay cable RY1-RYn as a connection state by controlling the signal state supplied to the coil L11 of the relay cable RY1-RYn connected with the plug hole 211-21n, and supplies power from the power supply cable 10 to the plug hole 211-21n SB. Due to this, power is supplied to the electrical appliance and it makes the electrical appliance operate.

The step SB in FIG. 9 will be described with the example of FIG. 10.

The standby current consumed by a newly connected electrical appliance can be automatically determined.

Therefore, the electrical outlet control part 24 cases the state of the relay cable RY1-RYn to be connected (i.e., switch SW11 and SW12 are turned on) by controlling the signal state supplied to the coil L11 of the relay cable RY1-RYn connected with the plug hole 211-21n. This operation state of the relay cable RY1-RYn can be saved as an electrical outlet state data to the storage 25, as well.

Due to this connection state of the relay cable RY1-RYn), power is supplied from the power supply cable 10 to the plug hole 211-21n connected with a new electrical appliance at the step SB.

Later, whether the standby current value is registered (set) can be checked at step S18. This is to use the electronic device fast by a user's advance registering the standby current of the electrical device to be used and skipping the process of identifying the standby current.

The step SC in FIG. 9 will be described with the example of FIG. 10.

The electrical outlet control part 24 can decode the current detecting signal B1-Bn supplied from the current detector 231-23n connected with the plug hole 211-21n for predetermined time at steps S110 and S111, measures (calculates) the current consumption value (i.e., the current value to be used to measure standby current) consumed by the plug hole 211-21n at step, and registers (saves) it as the standby current at step S113.

At this moment, the average value of the signal of the measured current (a sine wave, effective value, etc.) can be determined as the standby current.

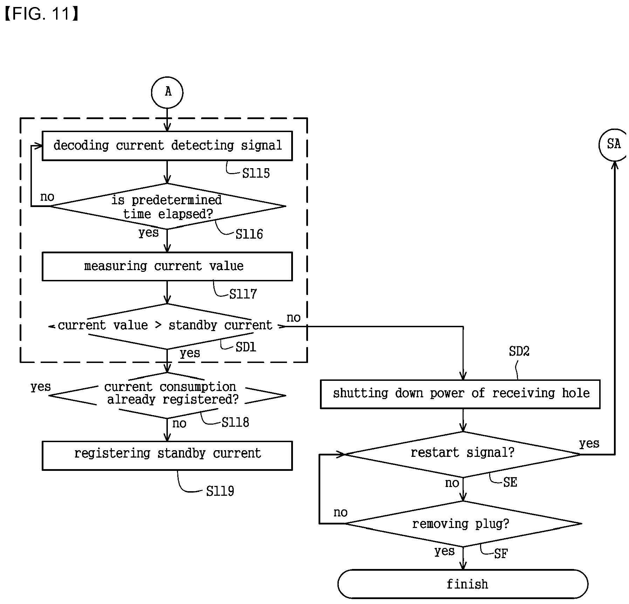

The step SD in FIG. 9 will be described with the example of FIG. 11.

When the standby current of the electrical appliance is completely determined at the step SC, the electrical outlet control part 24 decodes the current detecting signal B1-Bn supplied from the current detector 231-23n connected with the plug hole 211-21n for predetermined time at steps S115 and S116, and measures (calculates) the current consumption value at the step S117.

Then, using the data saved to the storage 25, the electrical outlet control part 24 determines whether the current value measured for predetermined time is larger than the standby current of the plug hole 211-21n at step SD1.

If the measured current value is larger than the standby current of the plug hole 211-21n, the electrical outlet control part 24 determines that the electrical appliance inserted to the plug hole 211-21n is in motion.

Therefore, using the control signal supplied to the relay cable RY1-RYn, the electrical outlet control part 24 maintains the connection state of the relay cable RY1-RYn. In addition, power is supplied to the plug hole 211-21n through the power supply cable 10 and it makes the electrical appliance operate normally. In this case, the measured current consumption value of the electrical outlet plug 211-21n can be saved as a part of electrical outlet state data.

After that, it is determined whether the current consumption value is registered (set) at step S118

This can be used to find out the operation state of the electrical appliance or whether the electrical appliance is defected by a user's advance registering the current consumption of an electrical device to be used. If there is no registered (set) current consumption value, the currently measured current value can be registered (saved) as current consumption at step S119.

However, if the current value measured in SD1 stage is less than the standby current, the electrical outlet control part 24 determines that the electrical appliance connected with the plug hole 211-21n is not in motion for predetermined time and consumes the standby current.

Therefore, the electrical outlet control part 24 controls the state of the relay cable RY1-RYn connected with the plug hole 211-21n as the disconnection state, shuts off the power from the power supply cable 10 SD2 not to be supplied to the electrical appliance which is not in motion, and prevents the electrical appliance from consuming the standby current.

In other words, in case that the electrical appliance inserted to the plug hole 211-21n is in motion, power is supplied from the power supply cable 10 to the plug hole 211-21n by controlling the state of the relay cable RY1-RYn as the connection state. On the contrary, in case that the electrical appliance inserted to the plug hole 211-21n is not in motion, power from the power supply cable 10 is blocked by controlling the state of the relay cable RY1-RYn as the disconnection state, the standby current consumption of the plug hole 211-21n is prevented, and the electricity consumption by the standby power consumption is prevented consequentially.

The operation of the transmission device 30 which receives the electrical outlet state data transmitted from the power connect device 20 will be described referring to FIG. 12.

Referring to FIG. 12, when the operation of the transmission control part 30 is also started by starting the operation of the transmission device 30, whether the electrical outlet state data is transmitted from the power connect device 20 through the communication part 31 is determined at step S21.

When the electrical outlet state data is transmitted from the power connect device 20, the transmission control part 32 saves the transmitted electrical outlet state data to the storage 33 and transmits the electrical outlet state data saved to the storage 33 to the electrical outlet monitoring device 40 through the communications network 60 at every scheduled time at steps S23 to S25.

In the above, the example of transmitting data at every scheduled time is described with reference to FIG. 12, but the present invention is not limited to this. It is certain that data can be transmitted whenever a state changes, such as an event occurrence or a change of detected information (PS_ code change in FIG. 7 to FIG. 8).

Referring to FIG. 13, the operation of the electrical outlet monitoring device 40 which monitors the operation state of the power connect device 20 using the electrical outlet state data transmitted from the transmission device 30 will be described.

When the monitoring control part 41 is operated by starting the operation of the electrical outlet monitoring device 40 at step S30, the monitoring control part 41 determines whether the electrical outlet state data was transmitted to the transmission device 30 through the communication part 31 of the transmission device 30 at step S31.

When the electrical outlet state data is transmitted, the monitoring control part 41 saves the transmitted electrical outlet state data to the storage 50 at step S32.

After that, the monitoring control part 41 outputs the transmitted electrical outlet state data to the data output part 42 at step S33 and causes the operation state of each plug hole 211-21n of the power connect device 20 to be displayed on the data output part 42.

Due to this, using the electrical outlet state data which is output to the data output part 42, a supervisor figures out the standby current of each plug hole 211-21n, current consumption, whether the electrical appliance is connected, whether the relay cable is in motion, etc. promptly and precisely.

While this invention has been described in connection with what is presently considered to be practical exemplary embodiments, it is to be understood that the invention is not limited to the disclosed embodiments, but, on the contrary, is intended to cover various modifications and equivalent arrangements included within the spirit and scope of the appended claims.

## Claims

1. A system of automatic setting and shutting down a standby current of an electrical outlet by plug insertion, the system comprising an electric outlet which comprises:
a plug hole into which a plug of an electrical appliance is insertable,
a detector for plug insertion outputting a plug insertion detecting signal corresponding to whether the plug of the electrical appliance is inserted in the plug hole,
a current detector outputting a current detecting signal corresponding to current flowing through the plug hole,
a switching part mounted between a power supply cable which supplies power and the plug hole, and
an electrical outlet control part connected with the detector for plug insertion, the current detector and the switching part,
wherein if the electrical outlet control part determines based on the plug insertion detecting signal output from the detector for plug insertion that the electrical appliance is inserted in the plug hole at current state, not inserted in the plug hole at previous state, the electrical outlet control part outputs a control signal to the switching part and causes the switching part to be connection state so as to supply power from the power supply cable to the plug hole, and the electrical outlet control part detects current currently consumed by the plug hole based on the current detecting signal transmitted from the current detector and determines the currently detected current as a standby current of the plug hole.

2. The system of claim 1, wherein the detector for plug insertion comprises:
a moving part disposed between an upper insertion hole and a middle insertion hole of the plug hole and being movable,
an elastic member connected with the moving part and changing a state thereof according to moving state of the moving part, and
a switch positioned close to the moving part and changing a contact state thereof according to the moving state of the moving part so as to output a plug insertion detecting signal of the corresponding state.

3. The system of claim 2, wherein the moving part is rotated, moved linearly to the left or the right, moved linearly and vertically by force applied due to insertion of the plug of the electrical appliance into the upper insertion hole such that the middle insertion hole is exposed.

4. The system of claim 3, wherein the switch comprises:
a contact plate changing a position thereof as the moving part moves,
a contact point positioned corresponding to the contact plate and contacting with the contact plate by movement of the moving part,
an input terminal applying a predetermined voltage, and
at least one output terminal outputting an output signal about whether the contact plate contacts with the contact point.

5. The system of claim 1, wherein the detector for plug insertion comprises:
a moving part disposed between an upper insertion hole and a middle insertion hole of the plug hole and being movable,
an elastic member connected with the moving part and changing a state thereof according to moving state of the moving part,
an operation pin configured to penetrate through a top plate and a middle plate of the electrical outlet and moving downward by force applied when the plug of the electrical appliances inserted into the upper insertion hole, and
a switch located below the operation pin, changing a contact state thereof according to downward movement of the operation pin, and outputting a plug insertion detecting signal corresponding state.

6. The system of claim 5, wherein the switch comprises:
a contact plate located below the operation pin and changing a position thereof according to downward movement of the operation pin,
a contact point positioned corresponding to the contact plate and contacting with the contact plate by downward movement of the operation pin,
an input terminal applying a predetermined voltage, and
at least one output terminal outputting an output signal about whether the contact plate contacts with the contact point.

7. The system of claim 1, wherein the plug hole is a plug hole of a USB type into which a USB plug is inserted, and
the power supply cable outputs power from a DC power supply part supplying DC power.

8. The system of claim 7, wherein the detector for plug insertion comprises a switch positioned close to the plug hole and changing a contact state thereof according to a state of a USB plug insertion so as to output a plug insertion detecting signal of the corresponding state.

9. The system of claim 8, wherein the switch comprises:
a contact plate changing a position thereof according to insertion of the USB plug,
a contact point positioned corresponding to the contact plate and contacting with the contact plate by the insertion of the USB plug,
an input terminal applying a predetermined voltage, and
at least one output terminal outputting an output signal about whether the contact plate contacts with the contact point.

10. The system of claim 1, further comprising an operation state indicator connected with the electrical outlet control part, and
wherein the electrical outlet control part operates the operation state indicator during detecting the current.

11. The system of claim 1, further comprising an operation state indicator connected with the electrical outlet control part, and
wherein the electrical outlet control part displays a state where power is applied to the plug hole on the operation state indicator so as to use the electrical appliance connected with the plug hole.

12. The system of claim 1, wherein if the electrical outlet control part determines based on the plug insertion detecting signal output from the detector for plug insertion that the electrical appliance is not inserted into the plug hole, the electrical outlet control part outputs a control signal to the switching part and causes the switching part to be disconnection state such that power supplied from the power supply cable to the plug hole is blocked.

13. The system of claim 1, further comprising an electrical outlet switch connected with the electrical outlet control part,
wherein if the electrical outlet control part determines based on the plug insertion detecting signal output from the detector for plug insertion that the electrical appliance is inserted in the plug hole from a previous state to a current state, the electrical outlet control part determines based on a signal transmitted from the electrical outlet switch whether the electrical outlet switch is operated,
wherein if the electrical outlet control part determines that the electrical outlet switch is operated, the electrical outlet control part controls a state of the switching part to become the connection state so as to supply power from the power supply cable to the plug hole,
wherein the electrical outlet control part decodes the current detection signal transmitted from the current detector to detects current measured by the plug hole, and
wherein the electrical outlet control part maintains the state of the switching part to be the connection state if the measured current exceeds the standby current of the electrical outlet plug, and controls the state of the switching part to become disconnection state if the measured current is the same as the standby current of the electrical outlet plug.

14. The system of claim 1, further comprising a transmission device communicating with the electrical outlet control part using power line communication, and
wherein the electrical outlet control part transmits the standby current of the plug hole, whether the electrical appliance is connected, current consumption, and whether the switching part is operated through the transmission device.

15. A detector for plug insertion comprising:
a moving part disposed between an upper insertion hole and a middle insertion hole of a plug hole and being movable,
an elastic member connected with the moving part and changing a state thereof according to moving state of the moving part, and
a switch positioned close to the moving part and changing a contact state thereof according to the moving state of the moving part so as to output a plug insertion detecting signal of the corresponding state.

16. The detector of claim 15, wherein the moving part is rotated, moved linearly to the left or the right, moved linearly and vertically by force applied due to insertion of the plug of the electrical appliance into the upper insertion hole such that the middle insertion hole is exposed.

17. The detector of claim 16, wherein the switch comprises:
a contact plate changing a position thereof as the moving part moves,
a contact point positioned corresponding to the contact plate and contacting with the contact plate by movement of the moving part, and
an output terminal changing a state of an output signal according to whether the contact plate contacts with the contact point.

18. A detector for plug insertion comprising:
a moving part disposed between an upper insertion hole and a middle insertion hole of a plug hole and being movable,
an elastic member connected with the moving part and changing a state thereof according to moving state of the moving part,
an operation pin configured to penetrate through a top plate and a middle plate of an electrical outlet and moving downward by force applied when a plug of an electrical appliances inserted into the upper insertion hole, and
a switch located below the operation pin, changing a contact state thereof according to downward movement of the operation pin, and outputting a plug insertion detecting signal corresponding state.

19. The system of claim 18, wherein the switch comprises::
a contact plate located below the operation pin and changing a position thereof according to downward movement of the operation pin,
a contact point positioned corresponding to the contact plate and contacting with the contact plate by downward movement of the operation pin,
an input terminal applying a predetermined voltage, and
at least one output terminal outputting an output signal about whether the contact plate contacts with the contact point.

20. A module of detecting USB plug insertion comprising:
a plug hole into which a USB plug is inserted (connected), and
a switch positioned close to the plug hole and changing a contact state thereof according to a state of a USB plug insertion so as to output a plug insertion detecting signal of the corresponding state, and
wherein the switch comprises:
a contact plate changing a position thereof according to insertion of the USB plug,
a contact point positioned corresponding to the contact plate and contacting with the contact plate by the insertion of the USB plug,
an input terminal applying a predetermined voltage, and
at least one output terminal outputting an output signal about whether the contact plate contacts with the contact point.

21. A method of controlling a system of automatic setting and shutting down a standby current of an electrical outlet by plug insertion, the method comprising:
a step where an electrical outlet control part decodes a plug insertion detecting signal output from a detector for plug insertion and determines whether an electrical appliance is inserted in a plug hole at current state, not inserted in the plug hole at previous state,
a step where if the electrical outlet control part determines that the electrical appliance is inserted in the plug hole at current state, not inserted in the plug hole at previous state, the electrical outlet control part controls a state of a switching part to be connection state and supplies power from a power supply cable to the plug hole,
a step where the electrical outlet control part decodes a current detecting signal transmitted from a current detector so as to detect a current measured at the plug hole and determines the current as a standby current of the plug hole, and
a step where the electrical outlet control part compares the currently measured current with the standby current of the plug hole, maintains the state of the switching part to be the connection state if the currently measured current exceeds the standby current of the plug hole, and controls the state of the switching part to be disconnection state so as to block power supply from the power supply cable to the plug hole if a predetermined period passes under the condition that the currently measured current is less than the standby current of the plug hole.

22. The method of claim 21, wherein the electrical outlet control part detects current measured at the plug hole and operates an operation state indicator connected with the electrical outlet control part during determining the measured current as the standby current of the plug hole.

23. The method of claim 21, further comprising a step where the electrical outlet control part compares the currently measured current with the standby current of the plug hole, detects the current measured at the plug hole based on the current detecting signal transmitted from the current detector if the currently measured current exceeds the standby current of the plug hole, and determines the current as current consumption of the plug hole.

24. The method of claim 21, wherein if a restart signal is input, the electrical outlet control part controls the state of the switching part to be the connection state so as to supply power from the power supply cable to the plug hole and sequentially perform from the step where the currently measured current is compared with the standby current of the plug hole.

25. The method of claim 21, further comprising a step where if it is determined based on the plug insertion detecting signal transmitted to the detector for plug insertion that the electrical appliance is not inserted into the plug hole, the electrical outlet control part outputs the control signal to the switching part so as to control the switching part to be disconnection state and blocks power supply from the power supply cable to the plug hole.

26. The method of claim 21, further comprising a step where if the states of all switching parts remain the disconnection states for a predetermined period time, the electrical outlet control part blocks drive power supplied to the electrical outlet control part.
